# EUROPÄISCHE PATENTSCHRIFT

(11) **EP 2 839 325 B1**
(45) Veröffentlichungstag und Bekanntmachung des Hinweises auf die Patenterteilung: **14.09.2016**
(21) Anmeldenummer: 13716308.5
(22) Anmeldetag: 16.04.2013
(51) Int. Cl.: G02B 5/18

(54) **REFLEXIONSBEUGUNGSGITTER UND VERFAHREN ZU DESSEN HERSTELLUNG**
REFLECTIVE DIFFRACTION GRATING AND METHOD FOR THE PRODUCTION THEREOF
GRILLE DE DIFFRACTION PAR RÉFLEXION ET PROCÉDÉ DE FABRICATION DE LADITE GRILLE DE DIFFRACTION PAR RÉFLEXION

(30) Priorität: 19.04.2012 DE 102012103443
(43) Veröffentlichungstag der Anmeldung: 25.02.2015
(73) Patentinhaber: Fraunhofer-Gesellschaft zur Förderung der angewandten Forschung e.V., 80686 München (DE)
(72) Erfinder: FUCHS, Frank, 07745 Jena (DE); ZEITNER, Uwe, D., 99423 Weimar (DE)
(74) Vertreter: Epping - Hermann - Fischer
(86) Internationale Anmeldenummer: PCT/EP2013/057924
(87) Internationale Veröffentlichungsnummer: WO 2013/156485

(56) Entgegenhaltungen:
- EP-A1- 1 674 895
- WO-A2-02/082130
- US-A1- 2005 231 806
- US-B2- 7 545 564
- T.CLAUSNITZER ET AL.: "Low-loss gratings for next-generation gravitational wave detectors", ADVANCES IN THIN-FILM COATINGS FOR OPTICAL APPLICATIONS II, 31. Dezember 2005 (2005-12-31), Seite 153-160, XP040207689,
- SHORE B W ET AL: "Design of high-efficiency dielectric reflection gratings", JOURNAL OF THE OPTICAL SOCIETY OF AMERICA. A, OPTICS AND IMAGE SCIENCE, OPTICAL SOCIETY OF AMERICA, US, Bd. 14, Nr. 5, 1. Mai 1997 (1997-05-01), Seiten 1124-1136, XP008122236, ISSN: 0740-3232
- QI HONGJI ET AL: "Innovations in structured thin film design and fabrication for optical applications", SEVENTH INTERNATIONAL CONFERENCE ON THIN FILM PHYSICS AND APPLICATIONS, SPIE, 1000 20TH ST. BELLINGHAM WA 98225-6705 USA, Bd. 7995, Nr. 1, 11. Oktober 2010 (2010-10-11), Seiten 1-7, XP060005381, DOI: 10.1117/12.888231 [gefunden am 2011-02-17]

## Beschreibung

Reflexionsbeugungsgitter und Verfahren zu dessen Herstellung Die Erfindung betrifft ein Reflexionsbeugungsgitter und ein Verfahren zu dessen Herstellung.

Diese Patentanmeldung beansprucht die Priorität der deutschen Patentanmeldung 10 2012 103 443.5.

Reflexionsbeugungsgitter können durch eine Oberflächengitterstruktur auf einem Reflektor realisiert sein. Als Reflektoren sind Metallschichten und dielektrische Interferenzschichtsysteme geeignet. Dielektrische Interferenzschichtsysteme weisen typischerweise eine Vielzahl alternierender niedrigbrechender und hochbrechender Schichten auf. Bei der Verwendung eines dielektrischen Interferenzschichtsystems als Reflektor wird die Gitterstruktur in der Regel als Oberflächengitter in einer vom Substrat abgewandten obersten Schicht des Interferenzschichtsystems ausgebildet.

Für einige Anwendungen erweist es sich als vorteilhaft, die Gitterstruktur in einer hochbrechenden Schicht des Interferenzschichtsystems zu realisieren. Insbesondere kann auf diese Weise die spektrale Bandbreite und/oder die Beugungseffizienz für eine gewünschte Beugungsordnung erhöht werden. Es erweist sich allerdings als schwierig, bekannte Trockenätzverfahren wie reaktives Ionenätzen oder reaktives Ionenstrahlätzen auf bestimmte hochbrechende Materialien anzuwenden, da sich diese nicht oder nur schlecht mittels derartiger Ätzverfahren strukturieren lassen. Die zur Strukturierung von Beugungsgittern mit Perioden von typischerweise < 1 µm eingesetzten Ätzprozesse erfordern im Allgemeinen eine für das Material und die Struktur des Gitters spezifische Optimierung. Hierbei erweisen sich vor allem die Homogenität des Ätzprozesses und die Profiltreue im Vergleich zum Design der Gitterstruktur als problematisch. Mit steigender Zahl der Materialoptionen erhöht sich der Optimierungsaufwand in entsprechendem Maße. Darüber hinaus gibt es zum Teil Wechselwirkungen zwischen verschiedenen Ätzprozessen, sodass Ätzanlagen zum Teil nur für einzelne Materialien und Ätzprozesskombinationen betrieben werden können.

Der Stand der Technik wird in den Veröffentlichungen T.CLAUSNITZER ET AL.: "Low-loss gratings for next-generation gravitational wave detectors", ADVANCES IN THIN-FILM COATINGS FOR OPTICAL APPLICATIONS II, 31. Dezember 2005 (2005-12-31), Seite 153-160; SHORE B W ET AL: "Design of high-efficiency dielectric reflection gratings", JOURNAL OF THE OPTICAL SOCIETY OF AMERICA. A, OPTICS AND IMAGE SCIENCE, OPTICAL SOCIETY OF AMERICA, US, Bd. 14, Nr. 5, 1. Mai 1997 (1997-05-01), Seiten 1124-1136; QI HONGJI ET AL: "Innovations in structured thin film design and fabrication for optical applications", SEVENTH INTERNATIONAL CONFERENCE ON THIN FILM PHYSICS AND APPLICATIONS, SPIE, 1000 20TH ST. BELLINGHAM WA 98225-6705 USA, Bd. 7995, Nr. 1, 11. Oktober 2010 (2010-10-11), Seiten 1-7, EP 1 674 895 A1, WO 02/082130 A2, US 2005/231806 A1 und US 7 545 564 B2 beschrieben.

Der Erfindung liegt die Aufgabe zugrunde, ein Reflexionsbeugungsgitter anzugeben, das sich durch eine hohe Beugungseffizienz und hohe spektrale Bandbreite auszeichnet. Weiterhin soll ein Verfahren zur Herstellung des Reflexionsbeugungsgitters angegeben werden, durch das sich das Reflexionsbeugungsgitter auf vergleichsweise einfache Weise herstellen lässt. Diese Aufgaben werden durch ein Reflexionsbeugungsgitter und ein Verfahren zu dessen Herstellung gemäß den unabhängigen Patentansprüchen gelöst. Vorteilhafte Ausgestaltungen und Weiterbildungen der Erfindung sind Gegenstand der abhängigen Ansprüche.

Gemäß zumindest einer Ausgestaltung umfasst das Reflexionsbeugungsgitter ein Substrat, auf das ein reflexionserhöhendes Interferenzschichtsystem aufgebracht ist. Das reflexionserhöhende Interferenzschichtsystem weist abwechselnde niedrigbrechende dielektrische Schichten mit einem Brechungsindex n1 und hochbrechende dielektrische Schichten mit einem Brechungsindex n2 > n1 auf. Die Begriffe "niedrigbrechend" und "hochbrechend" sind jeweils relativ zum Brechungsindex des anderen Schichttyps der abwechselnden Schichten zu verstehen. Unter niedrigbrechenden Schichten werden insbesondere solche Schichten verstanden, die einen Brechungsindex n1 ≤ 1,6 aufweisen. Unter hochbrechenden Schichten werden insbesondere solche Schichten verstanden, die einen Brechungsindex n2 > 1,6, vorzugsweise n2 > 2,0, aufweisen.

Das reflexionserhöhende Interferenzschichtsystem umfasst beispielsweise mindestens fünf, bevorzugt mindestens zehn abwechselnde hochbrechende und niedrigbrechende Schichten.

Das Reflexionsbeugungsgitter umfasst weiterhin ein Gitter, das eine Gitterstruktur aufweist, die in der obersten niedrigbrechenden Schicht auf einer vom Substrat abgewandten Seite des reflexionserhöhenden Interferenzschichtsystems ausgebildet ist, und eine Deckschicht, welche die Gitterstruktur konform bedeckt. Die Deckschicht weist einen Brechungsindex n3 > n1 auf.

Dadurch, dass die Gitterstruktur in der obersten niedrigbrechenden Schicht des Interferenzschichtsystems ausgebildet ist, kann auf eine in der Regel schwierige Optimierung des Ätzprozesses für ein hochbrechendes Material verzichtet werden. Um trotz der Ausbildung der Gitterstruktur in der niedrigbrechenden Schicht des Interferenzschichtsystems eine hohe Bandbreite und hohe Beugungseffizienz des Reflexionsbeugungsgitters zu erzielen, ist die in der niedrigbrechenden Schicht erzeugte Gitterstruktur mit einer Schicht mit einem höheren Brechungsindex n3 > n1 konform bedeckt. "Konform bedeckt" bedeutet in diesem Zusammenhang, dass die Deckschicht die Struktur der Gitterstruktur nachbildet und somit ein Gitter mit gleicher Gitterkonstante ausbildet. Insbesondere ist die Deckschicht nicht derart dick, dass sie die darunter liegende Gitterstruktur planarisiert. Eine derartige konforme Bedeckung der Gitterstruktur in der niedrigbrechenden Schicht mit dem Material der Deckschicht kann insbesondere durch Atomlagenabscheidung (ALD, Atomic Layer Deposition) realisiert werden. Alternativ kann beispielsweise chemische Gasphasenabscheidung (CVD, Chemical Vapor Deposition) zur Herstellung der Deckschicht eingesetzt werden.

Das Material der Deckschicht ist vorzugsweise ein hochbrechendes Material mit einem Brechungsindex n3 > 1,6, bevorzugt n3 > 2,0. Da das hochbrechende Material der Deckschicht mit einem Beschichtungsverfahren aufgebracht wird, ist vorteilhaft keine Strukturierung mit einem Ätzprozess notwendig.

Die in der obersten niedrigbrechenden Schicht erzeugte Gitterstruktur und die Deckschicht, welche die Gitterstruktur konform bedeckt, bilden ein Oberflächengitter auf dem reflexionserhöhenden Interferenzschichtsystem aus. Die Optimierung der Gitterstruktur und der Dicke der Deckschicht erfolgt vorzugsweise mit Hilfe rigoroser Methoden wie beispielsweise der RCWA (Rigorous Coupled Wave Analysis).

Die Deckschicht auf der Gitterstruktur ist vorzugsweise eine dielektrische Schicht. Bei einer bevorzugten Ausgestaltung ist die Deckschicht aus dem gleichen Material wie die hochbrechenden Schichten des Interferenzschichtsystems gebildet.

Bei einer bevorzugten Ausgestaltung ist der Brechungsindex n3 der Deckschicht um mindestens 0,4 größer als der Brechungsindex n1 der niedrigbrechenden Schichten. Auf diese Weise kann durch das Aufbringen der Deckschicht auf die oberste niedrigbrechende Schicht die Beugungseffizienz wesentlich erhöht werden.

Zur Erzielung einer besonders hohen Reflexion mit dem reflexionserhöhenden Interferenzschichtsystem ist der Brechungsindex der hochbrechenden Schichten n2 um mindestens 0,4 größer als der Brechungsindex n1 der niedrigbrechenden Schichten.

Die niedrigbrechenden Schichten weisen vorzugsweise ein Siliziumoxid, insbesondere Siliziumdioxid, auf. Siliziumdioxid kann vorteilhaft mit an sich bekannten Ätzprozessen strukturiert werden. Dadurch ergibt sich ein vergleichsweise geringer Herstellungsaufwand.

Die hochbrechenden Schichten des Interferenzschichtsystems enthalten vorzugsweise Titandioxid, Tantalpentoxid oder Hafniumoxid. Diese Materialien weisen vorteilhaft einen vergleichsweise hohen Brechungsindex auf, sodass sich ein vorteilhaft hoher Brechungsindexkontrast zu einem niedrigbrechenden dielektrischen Material wie beispielsweise Siliziumdioxid ergibt.

Bei einer bevorzugten Ausgestaltung enthält die Deckschicht Titandioxid, Tantalpentoxid oder Hafniumdioxid. Für die Deckschicht sind insbesondere die gleichen hochbrechenden Materialien geeignet wie für die hochbrechenden Schichten des Interferenzschichtsystems.

Die Deckschicht weist vorzugsweise ein Dicke zwischen 10 nm und 150 nm auf. Das Gitter, welches die Gitterstruktur in der obersten niedrigbrechenden Schicht sowie die Deckschicht umfasst, weist vorteilhaft eine Dicke zwischen 20 nm und 1000 nm auf. Die Periodenlänge des Gitters beträgt vorteilhaft weniger als 5 µm, bevorzugt weniger als 1 µm.

Bei dem Verfahren zur Herstellung des Reflexionsbeugungsgitters wird zunächst ein Substrat bereitgestellt und nachfolgend das reflexionserhöhende Interferenzschichtsystem, das abwechselnde niedrigbrechende dielektrische Schichten mit einem Brechungsindex n1 und hochbrechende dielektrische Schichten mit einem Brechungsindex n2 > n1 aufweist, abgeschieden. Das Abscheiden des reflexionserhöhenden Interferenzschichtsystems kann mit an sich bekannten Beschichtungsverfahren, insbesondere mit PVD- oder CVD-Verfahren wie beispielsweise thermischer Verdampfung, Elektronenstrahlverdampfung oder Sputtern erfolgen.

Bei der Herstellung des dielektrischen Interferenzschichtsystems wird als oberste Schicht eine niedrigbrechende Schicht aufgebracht. In der niedrigbrechenden obersten Schicht des dielektrischen Interferenzschichtsystems wird nachfolgend eine Gitterstruktur ausgebildet. Das Ausbilden der Gitterstruktur erfolgt vorteilhaft mittels eines Lithografieverfahrens, vorzugsweise mittels Elektronenstrahllithografie. Mittels des Lithografieverfahrens wird die Struktur in einem Maskenmaterial erzeugt und nachfolgend mittels eines Ätzprozesses, beispielsweise mit einem Trockenätzverfahren wie insbesondere reaktivem Ionenätzen oder reaktivem Ionenstrahlätzen in das Material der obersten niedrigbrechenden Schicht übertragen.

In einem weiteren Verfahrensschritt wird eine Deckschicht mit einem Brechungsindex n3 > n1 auf die Gitterstruktur derart aufgebracht, dass die Deckschicht die Gitterstruktur konform bedeckt. Um dies zu erreichen, erfolgt das Aufbringen der Deckschicht vorzugsweise mittels Atomlagenabscheidung (ALD). Alternativ können aber auch andere Beschichtungsverfahren wie beispielsweise chemische Gasphasenabscheidung (CVD) zum Aufbringen der Deckschicht eingesetzt werden.

Weitere vorteilhafte Ausgestaltungen des Verfahrens ergeben sich aus der vorherigen Beschreibung des Reflexionsbeugungsgitters und umgekehrt.

Die Erfindung wird im Folgenden anhand von Ausführungsbeispielen im Zusammenhang mit den Figuren 1 bis 3 näher erläutert.

Es zeigen:
- Figur 1: eine schematische Darstellung eines Querschnitts durch ein Ausführungsbeispiel des Reflexionsbeugungsgitters bei einem Zwischenschritt des Herstellungsverfahrens,
- Figur 2: eine schematische Darstellung eines Querschnitts durch ein Ausführungsbeispiel des Reflexionsbeugungsgitters, und
- Figur 3: eine graphische Darstellung der Beugungseffizienz in Abhängigkeit von der Wellenlänge λ für ein Ausführungsbeispiel des Reflexionsbeugungsgitters.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

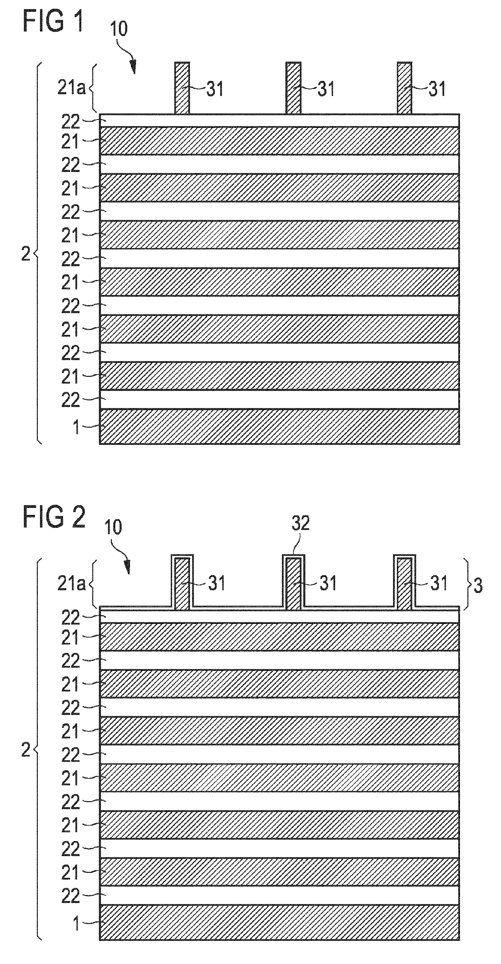

In Figur 1 ist das noch nicht fertiggestellte Reflexionsbeugungsgitter 10 bei einem Zwischenschritt des Herstellungsverfahrens dargestellt. Bei dem dargestellten Zwischenschritt ist bereits ein reflexionserhöhendes dielektrisches Interferenzschichtsystem 2, das mehrere abwechselnde niedrigbrechende Schichten 21 und hochbrechende Schichten 22 aufweist, auf ein Substrat 1 aufgebracht worden.

Das Substrat 1 des Reflexionsbeugungsgitters 10 kann beispielsweise Kieselglas (fused silica) aufweisen. Alternativ könnte auch ein anderes Substrat 1, vorzugsweise aus einem Glas, einer Glaskeramik oder einem Kunststoff, verwendet werden.

Bei den abwechselnden niedrigbrechenden Schichten 21 und hochbrechenden Schichten 22 des dielektrischen Interferenzschichtsystems 2 kann es sich insbesondere um Oxide, Nitride oder Fluoride handeln. Die niedrigbrechenden Schichten 21 enthalten vorzugsweise ein Siliziumoxid, insbesondere Siliziumdioxid (SiO₂). Die hochbrechenden Schichten 22 enthalten vorzugsweise Tantalpentoxid (Ta₂O₅), Titandioxid (TiO₂) oder Hafniumdioxid (HfO₂).

Die niedrigbrechenden Schichten 21 weisen vorteilhaft einen Brechungsindex n1 ≤ 1,6 und die hochbrechenden Schichten 22 einen Brechungsindex n2 > 1,6 auf. Um eine hohe Reflexion zu erzielen, gilt vorzugsweise n2 - n1 > 0,4. Auf diese Weise wird ein hoher Brechungsindexkontrast an den Grenzflächen des Interferenzschichtsystems 2 erzielt, wodurch sich die Reflexion des Schichtsystems erhöhen lässt.

In der obersten niedrigbrechenden Schicht 21a des reflexionserhöhenden Interferenzschichtsystems 2 ist eine Gitterstruktur 31 erzeugt worden. Die Gitterstruktur 31 kann beispielsweise durch eine lithografische Strukturierung einer Maske und nachfolgendes Übertragen der Struktur in die oberste niedrigbrechende Schicht 21a mittels eines Ätzprozesses erfolgen. Die lithografische Strukturierung kann insbesondere mittels Elektronenstrahllithografie erfolgen.

Hierbei ist es von Vorteil, dass die Gitterstruktur in der obersten niedrigbrechenden Schicht 21a des reflexionserhöhenden dielektrischen Schichtsystems 2 erzeugt wird, da sich eine niedrigbrechende Schicht wie vorzugsweise SiO₂ in vielen Fällen einfacher strukturieren lässt als typische hochbrechende Materialien, wobei insbesondere im Fall von SiO₂ an sich bekannte und bereits optimierte Trockenätzverfahren angewandt werden können.

Es hat sich aber herausgestellt, dass sich mit einem Reflexionsbeugungsgitter, bei dem die Gitterstruktur 31 in der obersten niedrigbrechenden Schicht 21a eines reflexionserhöhenden Interferenzschichtsystems 2 hergestellt ist, in der Regel nur eine geringere Beugungseffizienz und/oder spektrale Bandbreite erzielen lässt als mit einem Reflexionsbeugungsgitter mit einer Gitterstruktur in einer hochbrechenden Schicht.

Um diesen Nachteil weitgehend zu kompensieren, wird, wie bei dem in Figur 2 dargestellten Ausführungsbeispiel eines Reflexionsbeugungsgitters 10zu sehen ist, die Gitterstruktur 31 mit einer Deckschicht 32 konform bedeckt, wobei die Deckschicht 32 einen Brechungsindex n3 aufweist, der größer als der Brechungsindex n1 der obersten niedrigbrechenden Schicht 21a ist. Das Gitter 3 des Reflexionsbeugungsgitters 10 wird also durch die Gitterstruktur 31 mit der darauf aufgebrachten Deckschicht 32 gebildet. Die Deckschicht 32 ist vorteilhaft eine hochbrechende dielektrische Schicht mit einem Brechungsindex n3 > 1,6. Vorzugsweise ist der Brechungsindex n3 der Deckschicht 32 um mindestens 0,4 größer als der Brechungsindex n1 der obersten niedrigbrechenden Schicht 21a.

Die Deckschicht 32 weist bei einer vorteilhaften Ausgestaltung den gleichen Brechungsindex auf wie die hochbrechenden Schichten 22 des reflexionserhöhenden Interferenzschichtsystems 2, d.h. es gilt n2 = n3. In diesem Fall können das dielektrische Interferenzschichtsystem 2 und das Gitter 3 vorteilhaft aus nur zwei Materialien hergestellt werden. Es ist aber nicht zwingend notwendig, dass die Deckschicht 32 das gleiche Material wie die hochbrechenden Schichten 22 des reflexionserhöhenden Interferenzschichtsystems 2 aufweist. Es ist auch möglich, dass die Deckschicht 32 und die hochbrechenden Schichten 22 aus zwei verschiedenen hochbrechenden Materialien gebildet sind.

Die Deckschicht 32 bedeckt die Gitterstruktur 31 in der obersten niedrigbrechenden Schicht 21a konform, d. h. sie bildet die Form der Gitterstruktur nach, sodass sie ein Gitter mit der gleichen Gitterkonstante wie die Gitterstruktur ausbildet. Um die Gitterstruktur 31 konform mit der Deckschicht 32 zu bedecken, wird die Deckschicht 32 vorzugsweise mittels Atomlagenabscheidung aufgebracht.

Beim Design des Reflexionsbeugungsgitters 10 für eine spezifische Anwendung können so genannte rigorose Simulationsverfahren, insbesondere RCWA, eingesetzt werden. Dabei werden insbesondere die Parameter der Gitterstruktur 31, die Dicke der aufgebrachten Deckschicht 32 sowie die Brechungsindizes n1 und n3 der Gitterstruktur und der Deckschicht berücksichtigt.

Die Deckschicht 32 weist vorzugsweise eine Dicke zwischen 10 nm und 150 nm auf. Das Gitter, welches die Gitterstruktur 31 in der obersten niedrigbrechenden Schicht 21a sowie die Deckschicht 32 umfasst, weist vorteilhaft eine Dicke zwischen 20 nm und 1000 nm auf. Die Periodenlänge des Gitters beträgt vorteilhaft weniger als 5 µm, bevorzugt weniger als 1 µm.

Das Reflexionsgitter 10 vereint insbesondere die Vorteile der guten Strukturierbarkeit eines niedrigbrechenden Schichtmaterials wie beispielsweise SiO₂ mit den Vorteilen einer Gitterstruktur, die ein hochbrechendes Material aufweist.

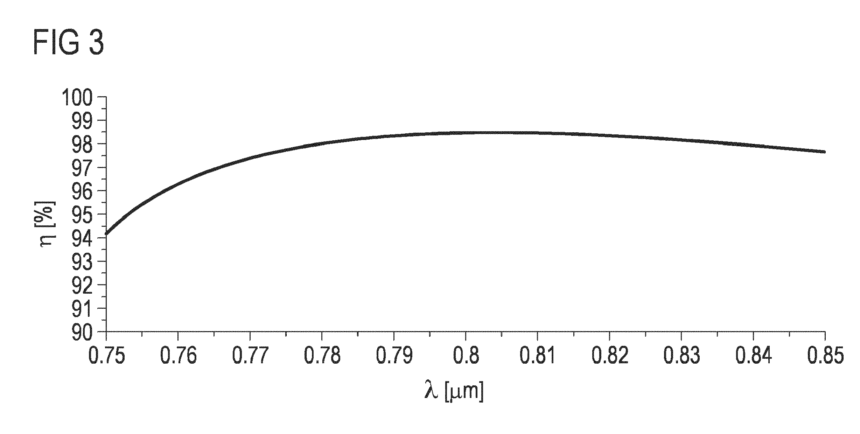

Fig. 3 zeigt eine grafische Darstellung der Beugungseffizienz η der -1. Beugungsordnung für das in Fig. 2 dargestellte Reflexionsbeugungsgitter in Abhängigkeit von der Wellenlänge λ. Das Reflexionsbeugungsgitter weist eine Gitterperiode von 555 nm auf. Dargestellt ist die berechnete Beugungseffizienz für TE-Polarisation bei einem Einfallswinkel von 57° aus Luft. Die Grafik verdeutlicht, dass das Reflexionsbeugungsgitter in dem dargestellten Wellenlängenbereich von 0,75 µm bis 0,85 µm eine vorteilhaft hohe Beugungseffizienz aufweist.

Die Erfindung ist nicht durch die Beschreibung anhand der Ausführungsbeispiele beschränkt.

## Patentansprüche

1. Reflexionsbeugungsgitter (10), umfassend
- ein Substrat (1),
- ein reflexionserhöhendes Interferenzschichtsystem (2), das abwechselnde niedrigbrechende dielektrische Schichten (21) mit einem Brechungsindex n1 und hochbrechende dielektrische Schichten (22) mit einem Brechungsindex n2 > n1 aufweist,
- ein Gitter (3), umfassend eine Gitterstruktur (31), die in der obersten niedrigbrechenden Schicht (21a) auf einer vom Substrat (1) abgewandten Seite des Interferenzschichtsystems (2) ausgebildet ist, und
- eine Deckschicht (32), welche die Gitterstruktur (31) konform bedeckt,
**dadurch gekennzeichnet, dass** die Deckschicht (32) einen Brechungsindex n3 > n1 aufweist.

2. Reflexionsbeugungsgitter nach Anspruch 1,
wobei für den Brechungsindex n3 der Deckschicht n3 > 1,6 gilt.

3. Reflexionsbeugungsgitter nach einem der vorhergehenden Ansprüche,
wobei die Deckschicht (32) eine dielektrische Schicht ist.

4. Reflexionsbeugungsgitter nach einem der vorhergehenden Ansprüche,
wobei die Deckschicht (32) aus dem gleichen Material wie die hochbrechenden Schichten (22) des Interferenzschichtsystems (2) gebildet ist.

5. Reflexionsbeugungsgitter nach einem der vorhergehenden Ansprüche,
wobei n₃ - n₁ ≥ 0,4 ist.

6. Reflexionsbeugungsgitter nach einem der vorhergehenden Ansprüche,
wobei n₂ - n₁ ≥ 0,4 ist.

7. Reflexionsbeugungsgitter nach einem der vorhergehenden Ansprüche,
wobei die niedrigbrechenden Schichten (21) Siliziumdioxid aufweisen.

8. Reflexionsbeugungsgitter nach einem der vorhergehenden Ansprüche,
wobei die hochbrechenden Schichten (22) Titandioxid, Tantalpentoxid oder Hafniumdioxid aufweisen.

9. Reflexionsbeugungsgitter nach einem der vorhergehenden Ansprüche,
wobei die Deckschicht (32) Titandioxid, Tantalpentoxid oder Hafniumdioxid aufweist.

10. Reflexionsbeugungsgitter nach einem der vorhergehenden Ansprüche,
wobei die Deckschicht (32) eine Dicke zwischen 10 nm und 150 nm aufweist.

11. Reflexionsbeugungsgitter nach einem der vorhergehenden Ansprüche,
wobei das Gitter (3) eine Dicke zwischen 20 nm und 1000 nm aufweist.

12. Reflexionsbeugungsgitter nach einem der vorhergehenden Ansprüche,
wobei das Gitter (3) eine Periodenlänge von weniger als 5 µm aufweist.

13. Verfahren zur Herstellung eines Reflexionsbeugungsgitters (10), umfassend die Schritte:
- Bereitstellen eines Substrats (1),
- Abscheiden eines reflexionserhöhenden Interferenzschichtsystems (2), das abwechselnde niedrigbrechende dielektrische Schichten (21) mit einem Brechungsindex n1 und hochbrechende dielektrische Schichten (22) mit einem Brechungsindex n2 > n1 aufweist,
- Erzeugen einer Gitterstruktur (31) in der obersten niedrigbrechenden Schicht (21a) des Interferenzschichtsystems (2),
- Aufbringen einer Deckschicht (32) auf die Gitterstruktur (31) derart, dass die Deckschicht (32) die Gitterstruktur (31) konform bedeckt,
**dadurch gekennzeichnet, dass**
- die Deckschicht (32) einen Brechungsindex n3 > n1 aufweist.

14. Verfahren nach Anspruch 13,
wobei die Deckschicht (32) mittels Atomlagenabscheidung (ALD) auf die Gitterstruktur (31) aufgebracht wird.

15. Verfahren nach Anspruch 13 oder 14,
wobei die Gitterstruktur (31) mittels Elektronenstrahllithografie erzeugt wird.

## Claims

1. Reflective diffraction grating (10), comprising
- a substrate (1),
- a reflection-enhancing interference layer system (2), which has alternating low refractive index dielectric layers (21) having a refractive index n1 and high refractive index dielectric layers (22) having a refractive index n2 > n1,
- a grating (3), comprising a grating structure (31), which is formed in the topmost low refractive index layer (21a) on a side of the interference layer system (2) facing away from the substrate (1), and
- a cover layer (32), which conformally covers the grating structure (31), **characterized in that** the cover layer (32) has a refractive index n3 > n1.

2. Reflective diffraction grating according to Claim 1,
wherein for the refractive index n3 of the cover layer it holds true that n3 > 1.6.

3. Reflective diffraction grating according to either of the preceding claims,
wherein the cover layer (32) is a dielectric layer.

4. Reflective diffraction grating according to any of the preceding claims,
wherein the cover layer (32) is formed from the same material as the high refractive index layers (22) of the interference layer system (2).

5. Reflective diffraction grating according to any of the preceding claims,
wherein n₃ - n₁ ≥ 0.4.

6. Reflective diffraction grating according to any of the preceding claims,
wherein n₂ - n₁ ≥ 0.4.

7. Reflective diffraction grating according to any of the preceding claims,
wherein the low refractive index layers (21) comprise silicon dioxide.

8. Reflective diffraction grating according to any of the preceding claims,
wherein the high refractive index layers (22) comprise titanium dioxide, tantalum pentoxide or hafnium dioxide.

9. Reflective diffraction grating according to any of the preceding claims,
wherein the cover layer (32) comprises titanium dioxide, tantalum pentoxide or hafnium dioxide.

10. Reflective diffraction grating according to any of the preceding claims,
wherein the cover layer (32) has a thickness of between 10 nm and 150 nm.

11. Reflective diffraction grating according to any of the preceding claims,
wherein the grating (3) has a thickness of between 20 nm and 1000 nm.

12. Reflective diffraction grating according to any of the preceding claims,
wherein the grating (3) has a period length of less than 5 µm.

13. Method for producing a reflective diffraction grating (10), comprising the following steps:
- providing a substrate (1),
- depositing a reflection-enhancing interference layer system (2), which has alternating low refractive index dielectric layers (21) having a refractive index n1 and high refractive index dielectric layers (22) having a refractive index n2 > n1,
- producing a grating structure (31) in the topmost low refractive index layer (21a) of the interference layer system (2),
- applying a cover layer (32) to the grating structure (31) in such a way that the cover layer (32) conformally covers the grating structure (31),
**characterized in that**
- the cover layer (32) has a refractive index n3>n1.

14. Method according to Claim 13,
wherein the cover layer (32) is applied to the grating structure (31) by means of atomic layer deposition (ALD).

15. Method according to Claim 13 or 14,
wherein the grating structure (31) is produced by means of electron beam lithography.

## Revendications

1. Réseau de diffraction par réflexion (10), comprenant
- un substrat (1),
- un système (2) de couches interférentielles augmentant la réflexion, qui comprend en alternance des couches diélectriques à faible indice de réfraction (21), ayant un indice de réfraction n1, et des couches diélectriques à haut indice de réfraction (22), ayant un indice de réfraction n2 > n1,
- un réseau (3), comprenant une structure de réseau (31), qui est réalisée dans la couche à faible indice de réfraction (21a) supérieure, sur un côté du système de couches interférentielles (2) opposé au substrat (1), et
- une couche de couverture (32), qui recouvre la structure de réseau (31) d'une manière conforme, **caractérisé en ce que** la couche de couverture (32) présente un indice de réfraction n3 > n1.

2. Réseau de diffraction par réflexion selon la revendication 1, dans lequel on a, pour l'indice de réfraction n3 de la couche de couverture, n3 > 1,6.

3. Réseau de diffraction par réflexion selon l'une des revendications précédentes, dans lequel la couche de couverture (32) est une couche diélectrique.

4. Réseau de diffraction par réflexion selon l'une des revendications précédentes, dans lequel la couche de couverture (32) est formée à partir du même matériau que les couches à haut indice de réfraction (22) du système de couches interférentielles (2).

5. Réseau de diffraction par réflexion selon l'une des revendications précédentes, dans lequel n₃ - n₁ ≥ 0,4.

6. Réseau de diffraction par réflexion selon l'une des revendications précédentes, dans lequel n₂ - n₁ ≥ 0,4.

7. Réseau de diffraction par réflexion selon l'une des revendications précédentes, dans lequel les couches à faible indice de réfraction (21) comprennent du dioxyde de silicium.

8. Réseau de diffraction par réflexion selon l'une des revendications précédentes, dans lequel les couches à haut indice de réfraction (22) comprennent du dioxyde de titane, du pentoxyde de tantale ou du dioxyde de hafnium.

9. Réseau de diffraction par réflexion selon l'une des revendications précédentes, dans lequel la couche de couverture (32) comprend du dioxyde de titane, du pentoxyde de tantale ou du dioxyde de hafnium.

10. Réseau de diffraction par réflexion selon l'une des revendications précédentes, dans lequel la couche de couverture (32) présente une épaisseur comprise entre 10 nm et 150 nm.

11. Réseau de diffraction par réflexion selon l'une des revendications précédentes, dans lequel le réseau (3) présente une épaisseur comprise entre 20 nm et 1000 nm.

12. Réseau de diffraction par réflexion selon l'une des revendications précédentes, dans lequel le réseau (3) présente un pas inférieur à 5 µm.

13. Procédé de fabrication d'un réseau de diffraction par réflexion (10), comprenant les étapes :
- mise à disposition d'un substrat (1),
- dépôt d'un système de couches interférentielles (2) augmentant la réflexion, qui comprend en alternance des couches diélectriques à faible indice de réfraction (21), ayant un indice de réfraction n1, et des couches diélectriques à haut indice de réfraction (22), ayant un indice de réfraction n2 > n1,
- production d'une structure de réseau (31) dans la couche à faible indice de réfraction (21a) supérieure du système de couches interférentielles (2),
- application d'une couche de couverture (32) sur la structure de réseau (31) de telle sorte que la couche de couverture (32) recouvre d'une manière conforme la structure de réseau (31),
**caractérisé en ce que**
- la couche de couverture (32) présente un indice de réfraction n3 > n1.

14. Procédé selon la revendication 13, dans lequel la couche de couverture (32) est appliquée sur la couche de réseau (31) par dépôt de couches atomiques (ALD).

15. Procédé selon la revendication 13 ou 14, dans lequel la structure de réseau (31) est produite par lithographie par faisceau d'électrons.
